# EUROPEAN PATENT APPLICATION

(11) **EP 4 615 181 A1**
(43) Date of publication of application: **10.09.2025**
(21) Application number: 23917120.0
(22) Date of filing: 26.10.2023
(51) Int. Cl.: H05K 7/20, H02M 7/42

(54) **INVERTER, POWER DEVICE, AND PHOTOVOLTAIC SYSTEM**

(30) Priority: 17.01.2023 CN 202310089428
(71) Applicant: Huawei Digital Power Technologies Co., Ltd., Shenzhen, Guangdong 518043 (CN)
(72) Inventor: SUN, Faming, Shenzhen, Guangdong 518043 (CN); YUAN, Bo, Shenzhen, Guangdong 518043 (CN); LI, Quanming, Shenzhen, Guangdong 518043 (CN); MENG, Hao, Shenzhen, Guangdong 518043 (CN)
(74) Representative: Maiwald GmbH
(86) International application number: PCT/CN2023/126838
(87) International publication number: WO 2024/152652

(57) **Abstract**

This application provides an inverter, a power device, and a photovoltaic system, to improve heat dissipation performance of the power device like the inverter, and further improve use reliability of the power device. For example, the power device is the inverter, and the power device may usually include a housing and a heat dissipation apparatus. The housing may include a first cavity and a second cavity, and a power semiconductor device is disposed in the first cavity. The second cavity has a first air inlet and a first air outlet, and a magnetic component is disposed in the second cavity. The heat dissipation apparatus includes a radiator and a first fan. The radiator includes an evaporator and a condenser that are connected to each other. The evaporator is disposed in the second cavity. The power semiconductor device is in thermally conductive contact with the evaporator, to dissipate heat for the power semiconductor device. The first fan is disposed in the second cavity, an air inlet side of the first fan faces the first air inlet, and an air outlet side of the first fan faces the first air outlet. **In** this case, the evaporator and the magnetic component share the first fan. This helps reduce a floor area of the inverter.

## Description

### CROSS-REFERENCE TO RELATED APPLICATIONS

This application claims priority to Chinese Patent Application No. 202310089428.7, filed with the China National Intellectual Property Administration on January 17, 2023 and entitled "INVERTER, POWER DEVICE, AND PHOTOVOLTAIC SYSTEM", which is incorporated herein by reference in its entirety.

### TECHNICAL FIELD

This application relates to the field of heat dissipation technologies, and in particular, to an inverter, a power device, and a photovoltaic system.

### BACKGROUND

As power of an inverter increases, heat generated by structures such as a board, an on-board component, and a cable inside an inverter cabinet also increases. Because high-power components such as a power semiconductor device are all disposed inside the cabinet, and a loss of the power semiconductor device accounts for about 70% of a total loss of the inverter, a heat consumption density of the power semiconductor device is high, and conventional air-cooling heat dissipation cannot meet a heat dissipation requirement of the power semiconductor device whose power continuously increases. This greatly affects performance of the power semiconductor device. In addition, the inverter cabinet naturally dissipates heat to the outside mainly through a wall surface of the cabinet. However, a heat dissipation capability of this heat dissipation manner is limited. As a result, effective cooling cannot be implemented inside the cabinet. This affects a service life and reliability of an internal component, and further affects an overall service life of the inverter.

Therefore, how to effectively dissipate heat for the component inside the cabinet to improve heat dissipation performance of the inverter has become a technical problem to be urgently resolved at present.

### SUMMARY

This application provides an inverter, a power device, and a photovoltaic system, to improve heat dissipation performance of the power device like the inverter, and further improve use reliability of the power device.

According to a first aspect, this application provides an inverter. The inverter may include a housing and a heat dissipation apparatus. The housing includes a first cavity and a second cavity, the first cavity may be a cavity with a high protection level, and a power semiconductor device may be disposed in the first cavity. The second cavity is a ventilation cavity, and the second cavity has a first air inlet and a first air outlet. **In** addition, a magnetic component may be disposed in the second cavity. The heat dissipation apparatus may include a radiator and a first fan, the radiator includes an evaporator and a condenser, and the evaporator is connected to the condenser through a two-phase pipeline. The evaporator may be disposed in the second cavity, and the power semiconductor device may be in thermally conductive contact with the evaporator. **In** this case, heat generated by the power semiconductor device may be conducted to the evaporator, to evaporate a liquid refrigerant in the evaporator into a gaseous state, this gaseous refrigerant may enter the condenser through a gas pipeline in the two-phase pipeline to be re-cooled and condensed into a liquid refrigerant, and then the liquid refrigerant flows back to the evaporator through a liquid pipeline in the two-phase pipeline under the action of gravity, to dissipate heat for the power semiconductor device.

**In** addition, the first fan may be disposed in the second cavity, an air inlet side of the first fan is disposed toward the first air inlet, and an air outlet side of the first fan may be disposed toward the first air outlet, to form a first air channel in the second cavity. The evaporator and the magnetic component may share the first fan and the first air channel, so that a heat dissipation capability of the inverter can be effectively improved, and power density of the inverter can be effectively increased. This can help improve performance reliability of each component in the inverter, and can further reduce a floor area of the inverter.

In addition to that the evaporator may be disposed in the second cavity, in a possible implementation of this application, the condenser may also be disposed in the second cavity. In addition, when the inverter is disposed in a gravity direction, the condenser may be located above the evaporator, so that the refrigerant condensed into the liquid state by the condenser can flow back to the evaporator under the action of gravity. Therefore, no driving mechanism needs to be disposed for circulation of the refrigerant between the evaporator and a condensing agent, thereby simplifying a structure of the radiator.

When the inverter is disposed in the gravity direction, specifically, when the condenser is disposed in the second cavity, the condenser may be located above the first cavity. In this case, the first air inlet of the second cavity may be disposed in a direction from the condenser to the first cavity, and the first air outlet may be disposed in a direction from the second cavity to the first cavity, so that the second cavity can be of a structure of an L-shaped cavity, and the first air channel is an L-shaped air channel. Such a disposing manner can help reduce the floor area of the inverter, and further facilitates arrangement and maintenance of the inverter.

In this application, to reduce a temperature of an airflow flowing through the condenser, an air supplement vent may be disposed in the second cavity, and the air supplement vent may be located on a side that is of the condenser and that faces the first air inlet. An airflow entering the second cavity through the air supplement vent can cool an airflow flowing in a direction from the first air inlet to the first air outlet. In addition, resistance to an airflow flowing in a direction from the first air inlet to the condenser can be effectively reduced. Therefore, the airflow flowing through the condenser can be increased, to improve cooling effect of the condenser, thereby improving heat dissipation effect of the entire inverter.

In addition to the L-shaped cavity, the second cavity may be a straight cavity. Specifically, the inverter may be disposed in the gravity direction, so that the second cavity is located above the first cavity. In this case, the first air inlet and the first air outlet may be disposed opposite to each other, and the first air channel formed in the second cavity is a straight air channel. Therefore, resistance to the airflow flowing in the second cavity can be reduced, so that the airflow flowing through the condenser is large. This can help improve cooling effect of the condenser, and can further improve heat dissipation effect of the entire inverter.

In a possible implementation of this application, the housing may further include a third cavity. The third cavity is also a ventilation cavity, and may include a second air inlet and a second air outlet. The heat dissipation apparatus may include a second fan. The second fan may be disposed in the third cavity, an air inlet side of the second fan is disposed toward the second air inlet, and an air outlet side of the second fan is disposed toward the second air outlet, to form a second air channel in the third cavity. In addition, the condenser may be disposed in the third cavity, and when the inverter is disposed in a gravity direction, the condenser may be located above the evaporator. The condenser is separately disposed in the third cavity, and the second fan is separately disposed for the condenser, so that an airflow flowing through the condenser can be effectively increased. This can help improve cooling effect of the condenser.

The condenser is disposed in the third cavity, the evaporator is disposed in the second cavity, and when the inverter is disposed in the gravity direction, the condenser may be located above the evaporator. Therefore, it can be learned that the third cavity may be located above the second cavity. Based on this, the second air inlet and the second air outlet may be disposed opposite to each other, so that the third cavity is a straight cavity.

In addition, in this application, a quantity of second fans in the third cavity is not limited. For example, there may be at least two second fans. The at least two second fans may be staggered in a direction from the second air inlet to the second air outlet, so that the airflow flowing through the condenser can be effectively increased.

To prevent heated airflow flowing out of the first air outlet of the second cavity from entering the third cavity, the second air outlet of the third cavity and the first air outlet of the second cavity may face a same direction, so that the second air inlet of the third cavity and the first air outlet of the second cavity face different directions.

**In** a possible implementation of this application, the evaporator may include a substrate and a heat dissipation fin. **In** this case, the power semiconductor device may be in thermally conductive contact with the substrate. **In** addition, the heat dissipation fin may be disposed on a side that is of the substrate and that is away from the first cavity, that is, the heat dissipation fin may be located in the second cavity. Therefore, when an airflow flows through the evaporator in a direction from the first air inlet to the first air outlet, heat at the heat dissipation fin may be taken away, to dissipate heat for the evaporator. This can effectively improve a heat dissipation capability of the radiator, and further improve heat dissipation efficiency of the radiator for the power semiconductor device.

In addition to an integrated structure, the evaporator may be of a split structure. Specifically, the evaporator may include a first sub-evaporator and a second sub-evaporator, the first sub-evaporator is disposed in the first cavity, and the second sub-evaporator is disposed in the second cavity. In this case, the power semiconductor device may be in thermally conductive contact with the second sub-evaporator. In addition, the first sub-evaporator and the second sub-evaporator may be connected to the condenser through the two-phase pipeline respectively. Therefore, hot air in the first cavity may heat a liquid refrigerant in the first sub-evaporator, to evaporate the liquid refrigerant into a gaseous state, this gaseous refrigerant may enter the condenser through the gas pipeline in the two-phase pipeline to be re-cooled and condensed into a liquid refrigerant, and then the liquid refrigerant flows back to the first sub-evaporator through the liquid pipeline in the two-phase pipeline, to dissipate heat for the first cavity. In addition, the heat generated by the power semiconductor device in the first cavity may evaporate a liquid refrigerant in the second sub-evaporator into a gaseous state, this gaseous refrigerant may enter the condenser through the gas pipeline in the two-phase pipeline to be re-cooled and condensed into a liquid refrigerant, and then the liquid refrigerant flows back to the second sub-evaporator through the liquid pipeline in the two-phase pipeline, to dissipate heat for the power semiconductor device. The disposing manner can effectively improve heat dissipation efficiency of the inverter, and further helps improve performance of each component in the inverter.

To dissipate heat for the first cavity, the inverter may further include a heat exchanger, the heat exchanger may be disposed in the second cavity, and the heat exchanger may be disposed on a first side wall of the first cavity. The heat exchanger may include an air supply vent and an air return vent. A first ventilation vent and a second ventilation vent may be disposed on the first side wall. **In** this case, the air supply vent may communicate with the first cavity through the first ventilation vent, and the air return vent may communicate with the first cavity through the second ventilation vent. Therefore, the heat exchanger may feed air into the first cavity through the air supply vent and the first ventilation vent, and the heated air in the first cavity returns to the heat exchanger through the air return vent and the second ventilation vent.

Because the heat exchanger is disposed in the first air channel, when an airflow in the first air channel flows through the heat exchanger, the air in the heat exchanger may be cooled. That is, after entering the heat exchanger, the heated air in the first cavity may exchange heat with the airflow in the first air channel, and cold air obtained through the heat exchange may be fed into the first cavity through the heat exchanger. In this way, heat dissipation for the first cavity can be implemented. This can help reduce a risk of a failure of each component in the first cavity.

In this application, the heat exchanger may alternatively be disposed in a split form. During specific implementation, the heat exchanger may include a first heat sub-exchanger and a second heat sub-exchanger, the first heat sub-exchanger is disposed in the first cavity, the second heat sub-exchanger is disposed in the second cavity, and the first heat sub-exchanger is in a thermally conductive connection to the second heat sub-exchanger, to dissipate heat for the first cavity through heat exchange between the first heat sub-exchanger and the second heat sub-exchanger.

In another possible implementation of this application, when the heat exchanger is disposed in the split form, the first heat sub-exchanger may be disposed in the first cavity, and the second heat sub-exchanger may alternatively be integrated with the condenser. In this case, the first heat sub-exchanger may alternatively be in a thermally conductive connection to the second heat sub-exchanger. Therefore, the second heat sub-exchanger and the condenser may share one evaporator. This can effectively improve integration of the inverter, and further facilitates a miniaturization design of the inverter.

According to a second aspect, this application further provides a power device. The power device may include a housing and a heat dissipation apparatus. The housing includes a first cavity and a second cavity, the first cavity may be a cavity with a high protection level, and a first to-be-heat-dissipated component may be disposed in the first cavity. The second cavity is a ventilation cavity, and the second cavity has a first air inlet and a first air outlet. In addition, a second to-be-heat-dissipated component may be disposed in the second cavity. The heat dissipation apparatus may include a radiator and a first fan, the radiator includes an evaporator and a condenser, and the evaporator is connected to the condenser through a two-phase pipeline. The evaporator may be disposed in the second cavity, and the first to-be-heat-dissipated component may be in thermally conductive contact with the evaporator. In this case, heat generated by the first to-be-heat-dissipated component may be conducted to the evaporator, to evaporate a liquid refrigerant in the evaporator into a gaseous state, this gaseous refrigerant may enter the condenser through a gas pipeline in the two-phase pipeline to be re-cooled and condensed into a liquid refrigerant, and then the liquid refrigerant flows back to the evaporator through a liquid pipeline in the two-phase pipeline under the action of gravity, to dissipate heat for the first to-be-heat-dissipated component.

In addition, the first fan may be disposed in the second cavity, an air inlet side of the first fan is disposed toward the first air inlet, and an air outlet side of the first fan may be disposed toward the first air outlet, to form a first air channel in the second cavity. The evaporator and the second to-be-heat-dissipated component may share the first fan and the first air channel, so that a heat dissipation capability of the power device can be effectively improved, and power density of the power device can be effectively increased. This can help improve performance reliability of each component in the power device, and can reduce a floor area of the power device.

According to a third aspect, this application further provides a power device. The power device may include a housing and a heat dissipation apparatus. The housing includes a first cavity and a second cavity, the first cavity may be a cavity with a high protection level, and a first to-be-heat-dissipated component may be disposed in the first cavity. The second cavity is a ventilation cavity, and the second cavity has a first air inlet and a first air outlet. In addition, a heat exchanger may be disposed in the second cavity. The heat dissipation apparatus may include a radiator and a first fan, the radiator includes an evaporator and a condenser, and the evaporator is connected to the condenser through a two-phase pipeline. The evaporator may be disposed in the second cavity, and the first to-be-heat-dissipated component may be in thermally conductive contact with the evaporator. In this case, heat generated by the first to-be-heat-dissipated component may be conducted to the evaporator, to evaporate a liquid refrigerant in the evaporator into a gaseous state, this gaseous refrigerant may enter the condenser through a gas pipeline in the two-phase pipeline to be re-cooled and condensed into a liquid refrigerant, and then the liquid refrigerant flows back to the evaporator through a liquid pipeline in the two-phase pipeline under the action of gravity, to dissipate heat for the first to-be-heat-dissipated component.

In addition, the first fan may be disposed in the second cavity, an air inlet side of the first fan is disposed toward the first air inlet, and an air outlet side of the first fan may be disposed toward the first air outlet, to form a first air channel in the second cavity. The evaporator and the heat exchanger may share the first fan and the first air channel, so that a heat dissipation capability of the power device can be effectively improved, and power density of the power device can be effectively increased. This can help improve performance reliability of each component in the power device, and can reduce a floor area of the power device.

When the heat exchanger is specifically disposed, the heat exchanger may include an air supply vent and an air return vent. A first ventilation vent and a second ventilation vent may be disposed on a first side wall. In this case, the air supply vent may communicate with the first cavity through the first ventilation vent, and the air return vent may communicate with the first cavity through the second ventilation vent. Therefore, the heat exchanger may feed air into the first cavity through the air supply vent and the first ventilation vent, and the heated air in the first cavity returns to the heat exchanger through the air return vent and the second ventilation vent.

Because the heat exchanger is disposed in the first air channel, when an airflow in the first air channel flows through the heat exchanger, the air in the heat exchanger may be cooled. That is, after entering the heat exchanger, the heated air in the first cavity may exchange heat with the airflow in the first air channel, and cold air obtained through the heat exchange may be fed into the first cavity through the heat exchanger. In this way, heat dissipation for the first cavity can be implemented. This can help reduce a risk of a failure of each component in the first cavity. Based on this, a to-be-heat-dissipated component like a magnetic component may further be disposed in the first cavity, and the to-be-heat-dissipated component has good performance.

According to a fourth aspect, this application further provides a photovoltaic system. The photovoltaic system may include a photovoltaic panel and the inverter in any possible implementation of the first aspect. The photovoltaic panel may be configured to convert solar energy into electric energy, and the inverter may be configured to perform power conversion on a current from the photovoltaic panel, or may be configured to perform power conversion on a voltage from the photovoltaic panel, so that output power of the photovoltaic system matches power of an external power-consuming device. Because heat dissipation performance of the inverter is good, reliability of the photovoltaic system is also improved.

According to a fifth aspect, this application further provides a photovoltaic system. The photovoltaic system may include a photovoltaic panel and the power device in the second aspect or the third aspect. The photovoltaic panel may be configured to convert solar energy into electric energy, and the power device may be configured to perform power conversion on a current from the photovoltaic panel, or may be configured to perform power conversion on a voltage from the photovoltaic panel, so that output power of the photovoltaic system matches power of an external power-consuming device. Because heat dissipation performance of the power device is good, reliability of the photovoltaic system is also improved.

According to a sixth aspect, this application further provides a photovoltaic system. The photovoltaic system may include at least two power devices, and the power device may include a housing and a heat dissipation apparatus. The housing includes a first cavity and a second cavity, the first cavity may be a cavity with a high protection level, and a first to-be-heat-dissipated component may be disposed in the first cavity. The second cavity is a ventilation cavity, and the second cavity has a first air inlet, a first air outlet, and an air supplement vent. In addition, a second to-be-heat-dissipated component may be disposed in the second cavity. The heat dissipation apparatus may include a radiator and a first fan, the radiator includes an evaporator and a condenser, and the evaporator is connected to the condenser through a two-phase pipeline. The evaporator may be disposed in the second cavity, and the first to-be-heat-dissipated component may be in thermally conductive contact with the evaporator. In this case, heat generated by the first to-be-heat-dissipated component may be conducted to the evaporator, to evaporate a liquid refrigerant in the evaporator into a gaseous state, this gaseous refrigerant may enter the condenser through a gas pipeline in the two-phase pipeline to be re-cooled and condensed into a liquid refrigerant, and then the liquid refrigerant flows back to the evaporator through a liquid pipeline in the two-phase pipeline under the action of gravity, to dissipate heat for the first to-be-heat-dissipated component.

In addition, the first fan may be disposed in the second cavity, an air inlet side of the first fan is disposed toward the first air inlet, and an air outlet side of the first fan may be disposed toward the first air outlet, to form a first air channel in the second cavity. The evaporator and the second to-be-heat-dissipated component may share the first fan and the first air channel, so that a heat dissipation capability of the power device can be effectively improved, and power density of the power device can be effectively increased. This can help improve performance reliability of each component in the power device, and can reduce a floor area of the power device.

In the photovoltaic system, the power device may be disposed in a gravity direction. In this case, the condenser may be located above the first cavity. The first air inlet may be disposed in a direction from the condenser to the first cavity, the first air outlet may be disposed in a direction from the second cavity to the first cavity, and the air supplement vent is located on a side that is of the condenser and that faces the first air inlet. In this case, when the at least two power devices are disposed side by side, an air deflector plate may be disposed between two adjacent power devices, and in a direction in which the at least two power devices are arranged, the air deflector plate may be configured to separate an air supplement vent of a former power device from a first air outlet of a latter power device. Therefore, an airflow flowing out of the first air outlet of the latter power device can be effectively prevented from entering the former power device through the air supplement vent, so that heat dissipation performance of each power device can be good, and reliability of the photovoltaic system can be improved.

### BRIEF DESCRIPTION OF DRAWINGS

FIG. 1 is a side sectional view of a power device according to an embodiment of this application;
FIG. 2a is a side sectional view of another power device according to an embodiment of this application;
FIG. 2b is a right view of the power device shown in FIG. 2a;
FIG. 3 is a diagram of a structure of a power device group according to an embodiment of this application;
FIG. 4a is a side sectional view of another power device according to an embodiment of this application;
FIG. 4b is a right view of the power device shown in FIG. 4a;
FIG. 5a is a side sectional view of another power device according to an embodiment of this application;
FIG. 5b is a right view of the power device shown in FIG. 5a;
FIG. 6 is a side sectional view of another power device according to an embodiment of this application;
FIG. 7 is a side sectional view of another power device according to an embodiment of this application;
FIG. 8 is a side sectional view of another power device according to an embodiment of this application;
FIG. 9 is a side sectional view of another power device according to an embodiment of this application;
FIG. 10 is a side sectional view of another power device according to an embodiment of this application;
FIG. 11 is a side sectional view of another power device according to an embodiment of this application;
FIG. 12 is a side sectional view of another power device according to an embodiment of this application;
FIG. 13 is a side sectional view of another power device according to an embodiment of this application;
FIG. 14 is a side sectional view of another power device according to an embodiment of this application;
FIG. 15a is a side sectional view of another power device according to an embodiment of this application;
FIG. 15b is a right view of the power device shown in FIG. 15a; and
FIG. 15c is a partial enlarged view of a structure of A in FIG. 15b.

### Reference numerals:

1: housing; 101: first cavity; 1011: first to-be-heat-dissipated component; 1012: power board; 1013: first side wall;
102: second cavity; 1021: first air inlet; 1022: first air outlet; 1023: second to-be-heat-dissipated component;
1024: air supplement vent; 1025: heat exchanger; 10251: first heat sub-exchanger; 10252: second heat sub-exchanger;
103: third cavity; 1031: second air inlet; 1032: second air outlet; 104: air deflector plate;
2: radiator; 201: evaporator; 2011: first sub-evaporator; 2012: second sub-evaporator; 2013: heat dissipation fin;
2014: substrate; 202: condenser; 203: two-phase pipeline; 2031: gas pipeline; 2032: liquid pipeline;
3-first fan; 4-second fan.

### DESCRIPTION OF EMBODIMENTS

To make the objectives, technical solutions, and advantages of this application clearer, the following further describes this application in detail with reference to accompanying drawings. However, example implementations may be implemented in a plurality of forms, and should not be construed as being limited to implementations described herein. Identical reference numerals in the figure denote identical or similar structures. Therefore, repeated descriptions thereof are omitted. Words that express positions and directions in embodiments of this application are described by using the accompanying drawings as an example. However, changes may also be made as required, and all the changes fall within the protection scope of this application. The accompanying drawings in embodiments of this application are merely used to illustrate relative position relationships and do not represent an actual scale.

It should be noted that specific details are set forth in the following descriptions for ease of understanding this application. However, this application can be implemented in a plurality of manners different from those described herein, and a person skilled in the art can perform similar promotion without departing from the connotation of this application. Therefore, this application is not limited to the specific implementations disclosed below.

To facilitate understanding of a power device and a photovoltaic system provided in this application, an application scenario of the power device and the photovoltaic system is first described. The photovoltaic system is a power generation system that converts solar energy into electric energy via photovoltaic effect of a semiconductor material. The photovoltaic system may usually include a photovoltaic panel and a power device. The photovoltaic panel may be configured to convert solar energy into electric energy, and the power device may be configured to perform power conversion on a current from the photovoltaic panel, or may be configured to perform power conversion on a voltage from the photovoltaic panel, so that output power of the photovoltaic system matches power of an external power-consuming device. For example, the power device includes but is not limited to an inverter, a rectifier, a chopper, or the like. In this embodiment of this application, a specific disposing manner of the power device is described by using an example in which the power device is an inverter.

As power of the power device increases, heat generated by components such as a board, an on-board component, and a cable inside a cabinet of the power device also increases. As a result, a temperature inside the cabinet increases, which is very unfavorable to the component disposed inside the cabinet. Especially for some power components with high heat consumption density, a risk of a failure of the power components increases significantly under the influence of a continuous high temperature.

Currently, conventional air-cooling heat dissipation cannot meet a heat dissipation requirement of the power device whose power density and heat consumption density continuously increase. As a result, effective cooling cannot be implemented inside the cabinet of the power device, a life and reliability of various components inside the cabinet cannot be ensured, and an overall service life of the power device is affected.

To resolve the foregoing problem, in embodiments of this application, a heat dissipation manner for the power device is improved, so that effective heat dissipation inside the power device can be implemented, to reduce a risk of a failure of the component inside the power device, and improve use reliability of the power device. The following specifically describes the power device provided in embodiments of this application with reference to accompanying drawings.

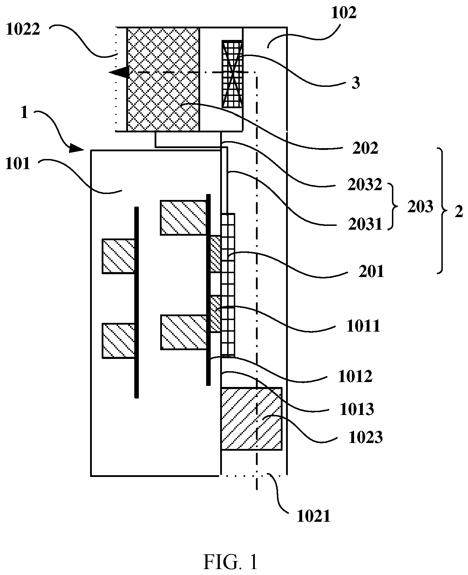

FIG. 1 is a side sectional view of a power device according to an embodiment of this application. In this embodiment, the power device may include a housing 1 and a heat dissipation apparatus. The housing 1 may include a first cavity 101 and a second cavity 102. The second cavity 102 may be disposed on a side of the first cavity 101, and the second cavity 102 may be fastened to the first cavity 101. In addition, the first cavity 101 may be a closed cavity, and the second cavity 102 may be a ventilation cavity. Therefore, in the power device, a component that has a high requirement on performance such as waterproof performance, dustproof performance, or corrosion resistance may be disposed in the first cavity 101, and a component that has no such protection requirement or has a low protection requirement may be disposed in the second cavity 102.

For example, a first to-be-heat-dissipated component 1011 may be disposed in the first cavity 101. The first to-be-heat-dissipated component 1011 may be a power component, for example, may be a power semiconductor device like an insulated gate bipolar transistor (insulated gate bipolar transistor, IGBT). Still refer to FIG. 1. The power device may further include a power board 1012 disposed in the first cavity 101, and the first to-be-heat-dissipated component 1011 may be specifically disposed on a surface that is of the power board 1012 and that faces the second cavity 102. In addition, there may be one or more first to-be-heat-dissipated components 1011. This is not limited in this application. It should be noted that, in addition to the power component, other electronic components such as a capacitor may also be disposed on the power board 1012. These electronic components may be disposed on the surface that is of the power board 1012 and that faces the second cavity 102, or may be disposed on a surface that is of the power board 1012 and that faces away from the second cavity 102. This is also not limited in this application.

Still refer to FIG. 1. The second cavity 102 may have a first air inlet 1021 and a first air outlet 1022. In this application, the second cavity 102 may be understood as a cover body or a pipeline structure. In addition, the heat dissipation apparatus may include a radiator 2. The radiator 2 includes an evaporator 201, a condenser 202, and a two-phase pipeline 203 configured to connect the evaporator 201 to the condenser 202. The two-phase pipeline 203 includes a gas pipeline 2031 and a liquid pipeline 2032. A liquid refrigerant in the evaporator 201 enters the condenser 202 through the gas pipeline 2031 after being heated and vaporized, and a refrigerant that is re-condensed into a liquid state by the condenser 202 may flow back to the evaporator through the liquid pipeline 2032 under the action of gravity.

In the power device shown in FIG. 1, the evaporator 201 may be disposed in the second cavity 102, and the evaporator 201 may be connected to a side wall of the first cavity 101. For ease of description, in the following embodiments of this application, the side wall that is of the first cavity 101 and that is used to connect to the second cavity 102 may be referred to as a first side wall 1013.

To transfer heat generated by the first to-be-heat-dissipated component 1011 to the evaporator 201, a mounting hole (not shown in FIG. 1) may be disposed on the first side wall 1013, and the mounting hole penetrates the first side wall 1013 in a direction from the first cavity 101 to the second cavity 102. Therefore, the first to-be-heat-dissipated component 1011 may be mounted in the mounting hole, and the first to-be-heat-dissipated component 1011 is in thermally conductive contact with the evaporator 201, so that the heat generated by the first to-be-heat-dissipated component 1011 can be directly transferred to the evaporator 201, to reduce a heat conduction path from the first to-be-heat-dissipated component 1011 to the evaporator 201. This can improve efficiency of heat conduction from the first to-be-heat-dissipated component 1011 to the evaporator 201.

It may be understood that, in this embodiment, when the evaporator 201 is disposed on the first side wall 1013, the evaporator 201 may block the mounting hole, so that the first cavity 101 has high sealing performance. In addition, when there are a plurality of first to-be-heat-dissipated components 1011, a mounting hole may be disposed at a position corresponding to each first to-be-heat-dissipated component 1011 on the first side wall 1013, so that each first to-be-heat-dissipated component 1011 can be in thermally conductive contact with the evaporator 201 through the corresponding mounting hole.

As shown in FIG. 1, the power device may be usually disposed in a gravity direction when being used. In this case, the condenser 202 may be disposed above the evaporator 201. Therefore, the heat generated by the first to-be-heat-dissipated component 1011 may evaporate the liquid refrigerant in the evaporator 201 into a gaseous state, this gaseous refrigerant may enter the condenser 202 through the gas pipeline 2031 in the two-phase pipeline 203 to be re-cooled and condensed into a liquid refrigerant, and then the liquid refrigerant flows back to the evaporator 201 under the action of gravity through the liquid pipeline 2032 in the two-phase pipeline 203, to dissipate heat for the first to-be-heat-dissipated component 1011.

To implement circulation of air in the second cavity 102, the heat dissipation apparatus may further include a first fan 3. The first fan 3 may be configured to enable the air to flow in a direction from the first air inlet 1021 to the first air outlet 1022. During specific implementation, an air inlet side of the first fan 3 may be disposed toward the first air inlet 1021, and an air outlet side of the first fan 3 may be disposed toward the first air outlet 1022, so that an airflow flowing in the direction from the first air inlet 1021 to the first air outlet 1022 can be formed in the second cavity 102, that is, a first air channel is formed in the second cavity 102. In the embodiment shown in FIG. 1, the condenser 202 may also be disposed in the second cavity 102, and the condenser 202 is disposed close to the first air outlet 1022. Therefore, the condenser 202 may be disposed in the first air channel, so that a gas entering the condenser 202 can be cooled through flowing of the airflow in the second cavity 102.

It may be understood that, to effectively cool the condenser 202, the first fan 3 may be disposed on a side that is of the condenser 202 and that faces the first air inlet 1021, or may be disposed on a side that is of the condenser 202 and that faces the first air outlet 1022. This is not specifically limited in this application, provided that the first air channel can be formed in the second cavity 102.

It can be learned from the foregoing description of the radiator 2 that the condenser 202 may be disposed above the evaporator 201 in the gravity direction. To reduce a floor area of the power device, in the embodiment shown in FIG. 1, the condenser 202 and the first cavity 101 may be arranged in the gravity direction. During specific implementation, in the gravity direction, the condenser 202 may be disposed above the first cavity 101.

In addition, in the power device shown in FIG. 1, the first side wall 1013 may be disposed in the gravity direction. Because the evaporator 201 is disposed on the first side wall 1013 of the first cavity 101, to dispose both the evaporator 201 and the condenser 202 in the first air channel, in a possible implementation, in the gravity direction, the first air inlet 1021 of the second cavity 102 may be disposed in a direction from the condenser 202 to the first cavity 101, that is, the first air inlet 1021 is disposed in a direction toward the bottom of the power device. The first air outlet 1022 of the second cavity 102 may be disposed in a direction from the second cavity 102 to the first cavity 101. Therefore, the second cavity 102 may be an L-shaped cavity, and an L-shaped first air channel for air intake from the bottom and air exhaust from the top may be formed in the second cavity 102.

Still refer to FIG. 1. In this embodiment of this application, a second to-be-heat-dissipated component 1023 may be further disposed in the second cavity 102. The second to-be-heat-dissipated component 1023 may be but is not limited to a magnetic component, and may be, for example, an inductor. The second to-be-heat-dissipated component 1023 may be disposed on the first side wall 1013 of the first cavity 101. In addition, in this embodiment of this application, relative positions of the second to-be-heat-dissipated component 1023 and the evaporator 201 in the second cavity 102 are not limited. For example, the second to-be-heat-dissipated component 1023 and the evaporator 201 may be disposed side by side or staggered in the gravity direction, for example, in the power device shown in FIG. 1, the second to-be-heat-dissipated component 1023 is located on a side that is of the evaporator 201 and that faces the first air inlet 1021; or in the gravity direction, the second to-be-heat-dissipated component 1023 and the evaporator 201 are located at a same height, and are disposed side by side or staggered.

It may be understood that, when the second to-be-heat-dissipated component 1023 is electrically connected to a component in the first cavity 101, a through hole may also be provided at a position that is on the first side wall 1013 and that corresponds to the second to-be-heat-dissipated component 1023, so that the second to-be-heat-dissipated component 1023 is electrically connected to the component in the first cavity 101 through a cable penetrating the through hole. In addition, when the second to-be-heat-dissipated component 1023 is disposed on the first side wall 1013, the second to-be-heat-dissipated component 1023 may block the through hole, to ensure sealing performance of the first cavity 101.

In the power device provided in this application, the first to-be-heat-dissipated component 1011 in the first cavity 101 is in direct contact with the evaporator 201, so that the heat generated by the first to-be-heat-dissipated component 1011 can be directly transferred to the evaporator 201, the liquid refrigerant in the evaporator 201 is evaporated into the gaseous state, this gaseous refrigerant may enter the condenser 202 through the gas pipeline 2031 in the two-phase pipeline 203 to be re-cooled and condensed into a liquid state, and then a liquid refrigerant flows back to the evaporator 201 under the action of the gravity through the liquid pipeline 2032 in the two-phase pipeline 203, to dissipate the heat for the first to-be-heat-dissipated component 1011. In addition, the radiator 2, the first fan 3, and the second to-be-heat-dissipated component 1023 are all disposed in the second cavity 102, in other words, the radiator 2 and the second to-be-heat-dissipated component 1023 share the first fan 3 and the first air channel, so that a size of the entire power device is small while implementing effective heat dissipation for the power device. Therefore, a heat dissipation capability of the power device provided in this application can be effectively improved, and power density of the power device can be effectively increased. This can help improve performance reliability of each component in the power device.

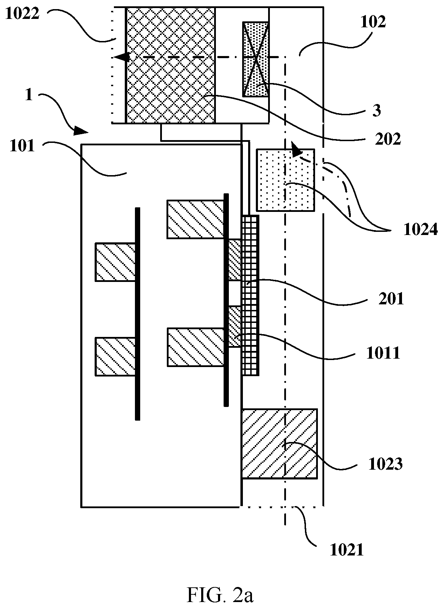

FIG. 2a is a side sectional view of another power device according to an embodiment of this application. A main difference between the power device and the power device shown in FIG. 1 lies in that, in the power device shown in FIG. 2a, an air supplement vent 1024 may be further disposed in the second cavity 102, and the air supplement vent 1024 may be located on a side that is of the condenser 202 and that faces the first air inlet 1021. Other structures of the power device shown in FIG. 2a may be disposed with reference to the power device in FIG. 1. Details are not described herein again.

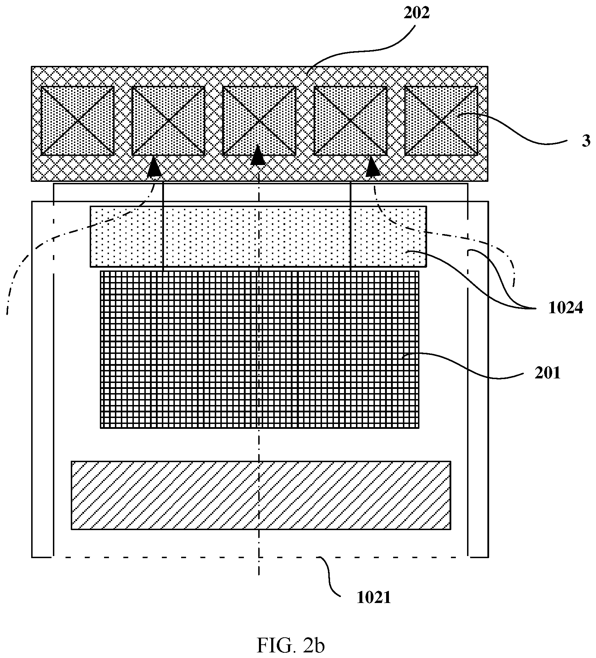

It may be understood that the air supplement vent 1024 may be disposed on any side wall surface of the second cavity 102. For example, refer to both FIG. 2a and FIG. 2b. FIG. 2b is a right view of the power device shown in FIG. 2a. The air supplement vent 1024 may be disposed on a side wall surface that is of the second cavity 102 and that is away from the first cavity 101, or may be disposed on another side wall surface of the second cavity 102. In addition, there may be one or at least two air supplement vents 1024. When there are at least two air supplement vents 1024, the at least two air supplement vents 1024 may be disposed on a same side wall surface, or may be disposed on different side wall surfaces of the second cavity 102 respectively. This is not specifically limited in this application.

In the power device shown in FIG. 2a, the air supplement vent 1024 is disposed in the second cavity 102, and the air supplement vent 1024 is located on the side that is of the condenser 202 and that faces the first air inlet 1021, so that a temperature of an airflow flowing through the condenser can be reduced, and resistance to an airflow flowing from the first air inlet 1021 to the condenser 202 in the first air channel can be effectively reduced. This can increase the airflow flowing through the condenser 202, to improve cooling effect of the condenser 202, and improve heat dissipation effect of the entire power device.

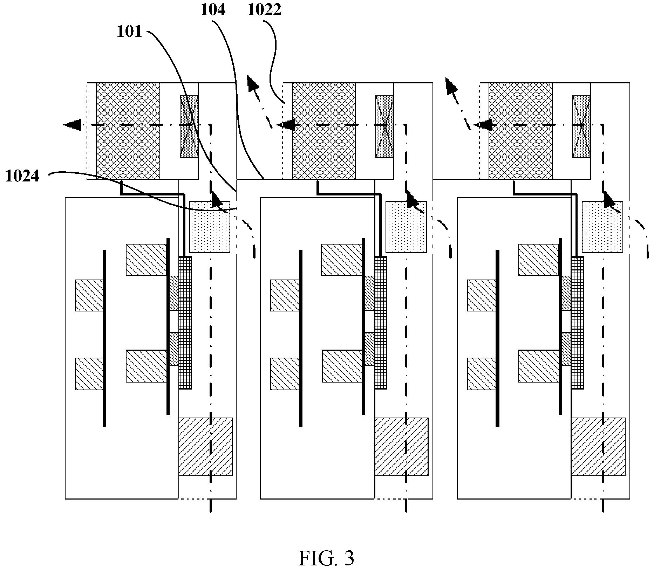

In some possible application scenarios, for example, in a large photovoltaic system, at least two power devices need to operate at the same time. In this case, the at least two power devices may be usually disposed side by side. During specific implementation, refer to FIG. 3. FIG. 3 is a diagram of a structure of at least two power devices disposed side by side as shown in FIG. 2a. It can be learned from the foregoing description of the power device shown in FIG. 2a that the air supplement vent 1024 is disposed on the side wall surface of the second cavity 102 of the power device. In this case, when the at least two power devices shown in FIG. 2a are disposed side by side, an air deflector plate 104 may be further disposed between two adjacent power devices. The air deflector plate 104 may be connected to the two adjacent power devices. For example, the air deflector plate 104 may be connected to outer side walls of second cavities 102 of the two adjacent power devices. In addition, in a direction in which the at least two power devices are arranged, the air deflector plate is configured to separate an air supplement vent of a former power device from a first air outlet of a latter power device. Therefore, an airflow flowing out of the first air outlet of the latter power device can be effectively prevented from entering the former power device through the air supplement vent, so that heat dissipation performance of each power device can be good, and reliability of the photovoltaic system can be improved.

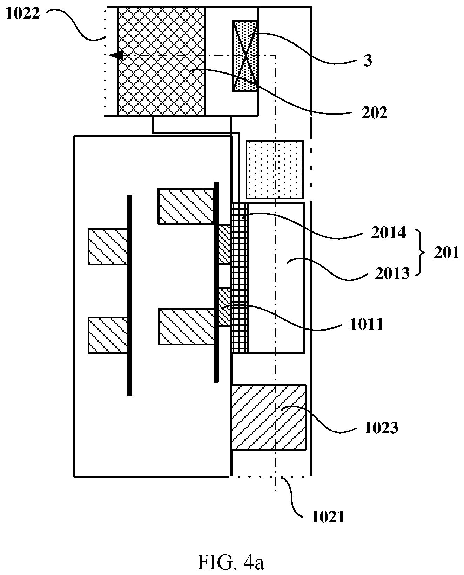

FIG. 4a is a side sectional view of another power device according to an embodiment of this application. In the power device shown in FIG. 4a, a heat dissipation fin 2013 may be further disposed on the evaporator 201, and the heat dissipation fin 2013 is disposed on a surface that is of a substrate 2014 of the evaporator 201 and that is away from the first cavity 101, that is, the heat dissipation fins 2013 is located in the second cavity 102. In addition, the first to-be-heat-dissipated component 1011 may be in thermally conductive contact with the substrate 2014.

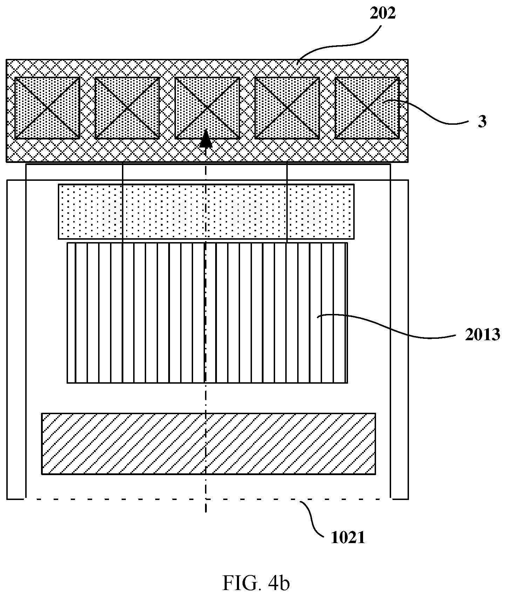

In addition, FIG. 4b is a right view of the power device shown in FIG. 4a. A quantity of heat dissipation fins 2013 is not specifically limited in this application. For example, there may be at least two heat dissipation fins 2013, and two adjacent heat dissipation fins 2013 are spaced from each other. Therefore, a gas circulation channel may be formed between the two heat dissipation fins 2013, and a flow direction of an airflow in the gas circulation channel may be consistent with a flow direction of an airflow in a first air channel, so that the airflow in the first air channel can flow through the gas circulation channel between the two heat dissipation fins 2013. This helps improve heat dissipation efficiency of cold air entering the second cavity 102 for the heat dissipation fin 2013. Other structures of the power device shown in FIG. 4a may be disposed with reference to the power device in FIG. 1 and/or the power device in FIG. 2a. Details are not described herein again.

In the power device shown in FIG. 4a, the heat dissipation fin 2013 is disposed on the evaporator 201, so that a heat dissipation area of the evaporator 201 can be effectively increased. In addition, because the evaporator 201 is disposed in the first air channel, that is, the heat dissipation fin 2013 is located in the first air channel, when an airflow flows through the evaporator 201 in a direction from the first air inlet 1021 to the first air outlet 1022, heat at the heat dissipation fin 2013 may be taken away, to dissipate heat for the evaporator 201. This can effectively improve a heat dissipation capability of the radiator 2, and further improve heat dissipation efficiency of the radiator 2 for the first to-be-heat-dissipated component 1011.

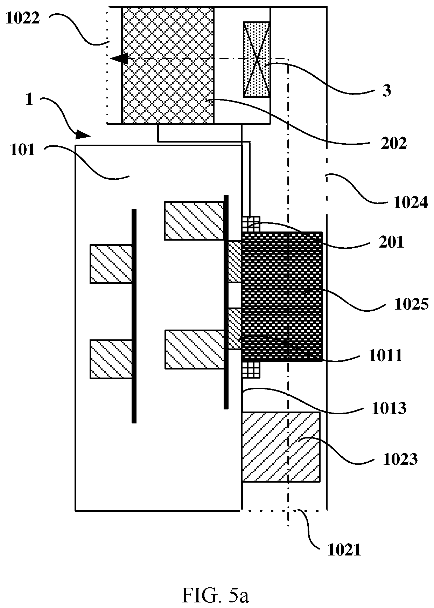

Because the first to-be-heat-dissipated component 1011 is disposed in the first cavity 101, and the first to-be-heat-dissipated component 1011 generates a large amount of heat, a part of the heat of the first to-be-heat-dissipated component 1011 is diffused into the first cavity 101. To effectively dissipate heat for the first cavity 101, refer to FIG. 5a. FIG. 5a is a side sectional view of another power device according to an embodiment of this application. The power device shown in FIG. 5a may further include a heat exchanger 1025. The heat exchanger 1025 may be disposed in the second cavity 102, that is, the heat exchanger 1025 is disposed in a first air channel. In addition, the heat exchanger 1025 may also be disposed on the first side wall 1013 of the first cavity 101.

The heat exchanger 1025 may usually include an air supply vent (not shown in FIG. 5a) and an air return vent (not shown in FIG. 5a). To implement heat exchange between the heat exchanger 1025 and the first cavity 101, when the heat exchanger 1025 is specifically disposed on the first side wall 1013, a first ventilation vent (not shown in FIG. 5a) and a second ventilation vent (not shown in FIG. 5a) may be disposed on the first side wall 1013. The air supply vent may communicate with the first cavity 101 through the first ventilation vent, and the air return vent may communicate with the first cavity 101 through the second ventilation vent. Therefore, the heat exchanger 1025 may feed air into the first cavity 101 through the air supply vent and the first ventilation vent, and the heated air in the first cavity 101 returns to the heat exchanger 1025 through the air return vent and the second ventilation vent.

Because the heat exchanger 1025 is disposed in the first air channel, when an airflow in the first air channel flows through the heat exchanger 1025, the air in the heat exchanger 1025 may be cooled. That is, after entering the heat exchanger 1025, the heated air in the first cavity 101 may exchange heat with the airflow in the first air channel, and cold air obtained through the heat exchange may be fed into the first cavity 101 through the heat exchanger 1025. In this way, heat dissipation for the first cavity 101 can be implemented. This can help reduce a risk of a failure of each component in the first cavity 101.

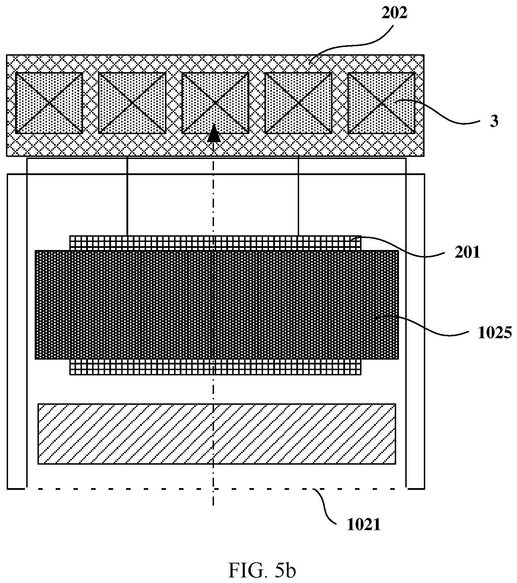

In the power device shown in FIG. 5a, a position at which the heat exchanger 1025 is disposed on the first side wall 1013 is not specifically limited. For example, the heat exchanger 1025 may be disposed on a side that is of the evaporator 201 and that faces the first air inlet 1021, or may be disposed on a side that is of the evaporator 201 and that faces the first air outlet 1022. In addition, FIG. 5b is a right view of the power device shown in FIG. 5a. In this embodiment, the heat exchanger 1025 may alternatively be disposed across the evaporator 201, in other words, the evaporator 201 may be located between the air supply vent and the air return vent of the heat exchanger 1025. Therefore, when the heat exchanger 1025 and the evaporator 201 share the first air channel, space in which the heat exchanger 1025 is disposed may further overlap space in which the evaporator 201 is disposed. This helps implement a design of reducing a size of the power device.

It should be noted that other structures of the power device shown in FIG. 5a and FIG. 5b may be disposed with reference to the power devices shown in FIG. 1 to FIG. 4b. Details are not described herein again. In addition, in some possible embodiments, when the heat exchanger 1025 is disposed in the second cavity 102, a magnetic component like an inductor may also be disposed in the first cavity 101. In this case, the heat exchanger 1025 may serve as a second to-be-heat-dissipated component 1023.

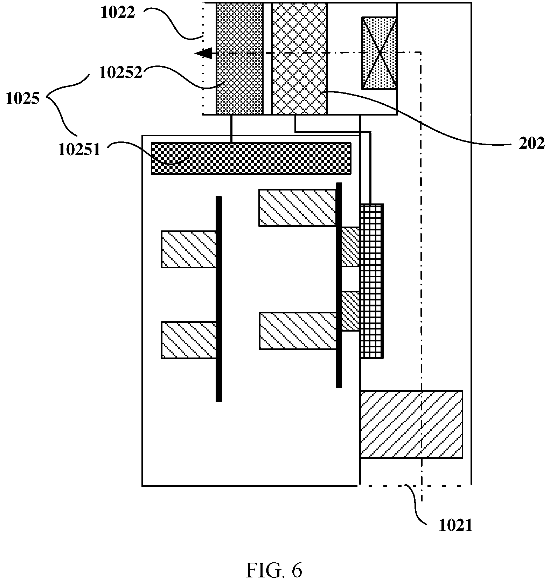

In this application, in addition to an integrated structure shown in FIG. 5a and FIG. 5b, the heat exchanger 1025 may further use a split structure. During specific implementation, refer to FIG. 6. FIG. 6 is a side sectional view of another power device according to an embodiment of this application. In the power device shown in FIG. 6, the heat exchanger 1025 may include a first heat sub-exchanger 10251 and a second heat sub-exchanger 10252. The first heat sub-exchanger 10251 is disposed in the first cavity 101, the second heat sub-exchanger 10252 is disposed in the second cavity 102, and the first heat sub-exchanger 10251 and the second heat sub-exchanger 10252 may be, but is not limited to, in a thermally conductive connection through a high thermal-conductivity element like a heat pipe, a two-phase pipeline, or the like.

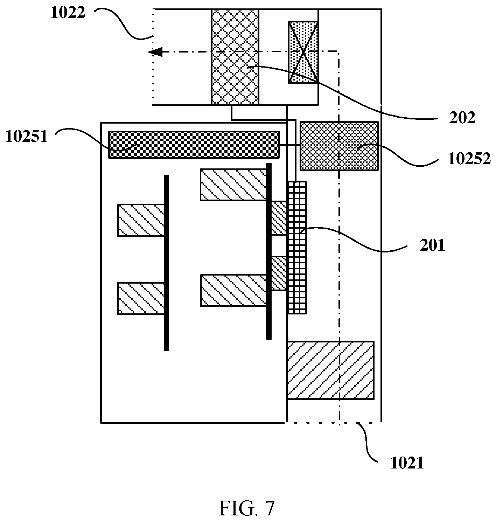

In addition, the first heat sub-exchanger 10251 may be disposed at any position in the first cavity 101. For example, in a gravity direction, the first heat sub-exchanger 10251 may be located at an upper end of the first cavity 101. The second heat sub-exchanger 10252 may be disposed at any position in the second cavity 102. For example, as shown in FIG. 6, the second heat sub-exchanger 10252 may be located on a side that is of the condenser 202 and that faces the first air outlet 1022. Alternatively, as shown in FIG. 7, the second heat sub-exchanger 10252 may be located between the evaporator 201 and the condenser 202. Alternatively, the second heat sub-exchanger 10252 may be disposed across the evaporator 201, so that space in which the second heat sub-exchanger 10252 is disposed overlaps space in which the evaporator 201 is disposed, thereby helping implement a design of reducing a size of the power device.

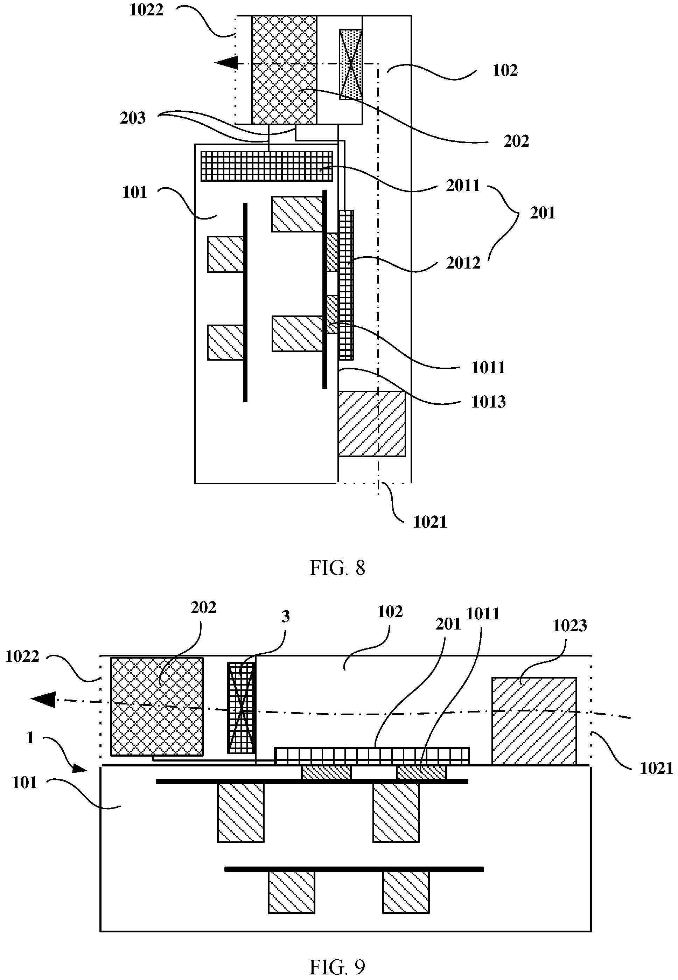

In addition, in addition to that the heat exchanger 1025 may be disposed as the split structure, in this application, the evaporator 201 may also be disposed as a split structure. During specific implementation, refer to FIG. 8. FIG. 8 is a side sectional view of another power device according to an embodiment of this application. In the power device shown in FIG. 8, the evaporator 201 may include a first sub-evaporator 2011 and a second sub-evaporator 2012. The first sub-evaporator 2011 is disposed in the first cavity 101, the second sub-evaporator 2012 is disposed in the second cavity 102, and the first sub-evaporator 2011 and the second sub-evaporator 2012 may share one condenser 202, that is, the first sub-evaporator 2011 and the second sub-evaporator 2012 may be connected to the same condenser 202 through the two-phase pipeline 203 respectively, so that integration of the radiator 2 can be effectively improved, and space occupied by the radiator 2 is small.

It may be understood that the first sub-evaporator 2011 may be disposed at any position of the first cavity 101. For example, in a gravity direction, the first sub-evaporator 2011 may be located at an upper end of the first cavity 101, so that a distance between the first sub-evaporator 2011 and the condenser 202 is small, and a length of the two-phase pipeline 203 connecting the first sub-evaporator 2011 to the condenser 202 is small. In addition, the second sub-evaporator 2012 may be disposed at any position of the second cavity 102, provided that the first to-be-heat-dissipated component 1011 in the first cavity 101 can be in thermally conductive contact with the second sub-evaporator 2012 through a mounting hole on the first side wall 1013.

In the power device shown in FIG. 8, hot air in the first cavity 101 may heat a liquid refrigerant in the first sub-evaporator 2011, to evaporate the liquid refrigerant into a gaseous state, this gaseous refrigerant may enter the condenser 202 through the gas pipeline 2031 in the two-phase pipeline 203 to be re-cooled and condensed into a liquid refrigerant, and then the liquid refrigerant flows back to the first sub-evaporator 2011 through the liquid pipeline 2032 in the two-phase pipeline 203, to dissipate heat for the first cavity 101. In addition, heat generated by the first to-be-heat-dissipated component 1011 in the first cavity 101 may evaporate a liquid refrigerant in the second sub-evaporator 2012 into a gaseous state, this gaseous refrigerant may enter the condenser 202 through the gas pipeline 2031 in the two-phase pipeline 203 to be re-cooled and condensed into a liquid refrigerant, and then the liquid refrigerant flows back to the second sub-evaporator 2012 through the liquid pipeline 2032 in the two-phase pipeline 203, to dissipate heat for the first to-be-heat-dissipated component 1011.

It should be noted that, in the power device shown in FIG. 8, a heat dissipation fin may also be disposed on the second sub-evaporator 2012. The heat dissipation fin may be disposed with reference to the heat dissipation fin 2013 of the evaporator 201 of the power device shown in FIG. 4a. Details are not described herein again. In addition, other structures of the power devices shown in FIG. 6 to FIG. 8 may be disposed with reference to the power devices shown in FIG. 1 to FIG. 5b. Details are not described herein again.

The second cavity 102 of the power device provided in each of the foregoing embodiments may be of an L-shaped structure, so that the first air channel formed in the second cavity 102 is an L-shaped air channel. In some other possible embodiments of this application, positions of the first air inlet 1021 and the first air outlet 1022 of the second cavity 102 may alternatively be opposite to each other, to form a straight first air channel in the second cavity 102.

During specific implementation, refer to FIG. 9. FIG. 9 is a side sectional view of another power device according to an embodiment of this application. In the power device shown in FIG. 9, the first cavity 101 and the second cavity 102 may be stacked. In addition, in a gravity direction, the second cavity 102 may be located above the first cavity 101. In this application, a power device in which devices are stacked may be referred to as a horizontal power device.

In this embodiment, the evaporator 201 may also be disposed on the first side wall 1013 of the first cavity 101. However, in the power device, the first side wall 1013 may be a top wall of the first cavity 101. The first to-be-heat-dissipated component 1011 in the first cavity 101 may also be in thermally conductive contact with the evaporator 201 through a mounting hole disposed on the first side wall 1013.

Still refer to FIG. 8. The condenser 202 may be located on a side that is of the evaporator 201 and that faces the first air outlet 1022. In addition, it may be understood that, to enable a refrigerant that is re-condensed into a liquid state by the condenser 202 to flow back to the evaporator 201, the condenser 202 may be located above the evaporator 201 in the gravity direction.

In the power device shown in FIG. 9, an air inlet side of the first fan 3 may be disposed toward the first air inlet 1021, and an air outlet side of the first fan 3 may be disposed toward the first air outlet 1022, so that an airflow flowing in a direction from the first air inlet 1021 to the first air outlet 1022 can be formed in the second cavity 102, that is, a first air channel is formed in the second cavity 102. Because resistance to be overcome in a flowing process of the airflow is small in the first air channel, an airflow flowing through the condenser 202 is large. This can effectively improve cooling effect of the condenser 202, and further improve heat dissipation effect of the entire power device.

In addition, the second to-be-heat-dissipated component 1023 may be disposed on a side that is of the condenser 202 and that faces the first air inlet 1021. Therefore, the radiator 2 and the second to-be-heat-dissipated component 1023 may share the first fan 3 and the first air channel, so that a size of the entire power device is small while implementing effective heat dissipation for the power device. Therefore, a heat dissipation capability of the power device provided in this application can be effectively improved, and power density of the power device can be effectively increased. This can help improve performance reliability of each component in the power device.

It may be understood that other structures of the power device shown in FIG. 9 may be disposed with reference to the power device shown in FIG. 1, and only disposing angles of the other structures need to be adaptively adjusted based on a direction in which the first cavity 101 and the second cavity 102 are arranged. Details are not described herein.

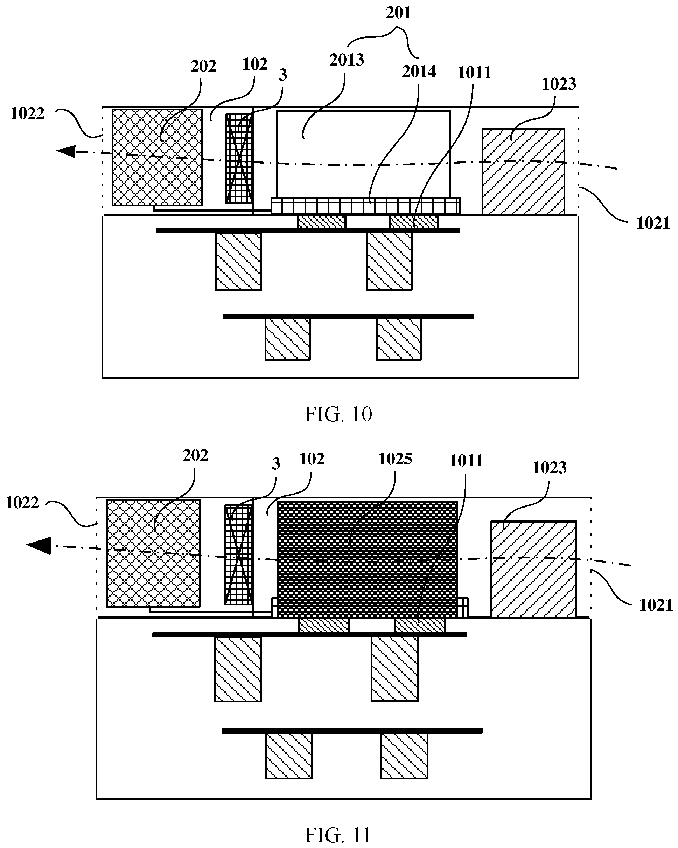

To improve heat dissipation effect of the horizontal power device, in a power device shown in FIG. 10, the heat dissipation fin 2013 may be disposed on the substrate 2014 of the evaporator 201, and the heat dissipation fin 2013 may be specifically disposed with reference to the heat dissipation fin 2013 of the power device in FIG. 4a. Details are not described herein again. In addition, other structures of the power device shown in FIG. 10 may be disposed with reference to the power device shown in FIG. 4a, and only disposing angles of the other structures need to be adaptively adjusted based on a direction in which the first cavity 101 and the second cavity 102 are arranged. Details are not described herein.

In addition, the heat exchanger 1025 is further disposed in a power device shown in FIG. 11, to dissipate heat for the first cavity 101 via the heat exchanger 1025, thereby improving heat dissipation effect of the entire horizontal power device. It should be noted that the heat exchanger 1025 of the power device shown in FIG. 11 may be disposed with reference to the heat exchanger 1025 of the power device in FIG. 5a. Details are not described herein again. In addition, other structures of the power device shown in FIG. 11 may be disposed with reference to the power device shown in FIG. 5a, and only disposing angles of the other structures need to be adaptively adjusted based on a direction in which the first cavity 101 and the second cavity 102 are arranged. Details are not described herein.

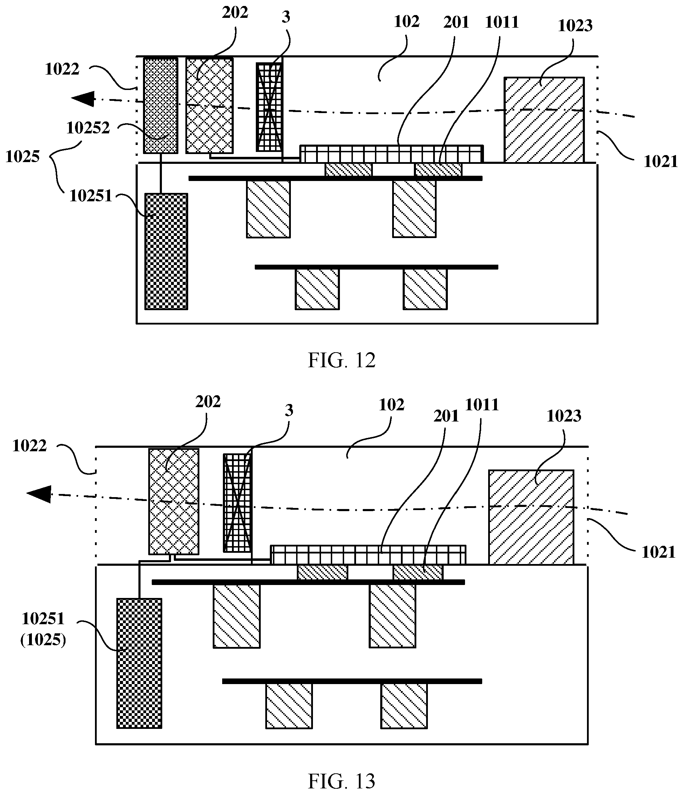

The heat exchanger 1025 of the power device shown in FIG. 6 may include the first heat sub-exchanger 10251 and the second heat sub-exchanger 10252. Based on this, in the horizontal power device, the heat exchanger 1025 may also be disposed as a split structure. For example, in a power device shown in FIG. 12, the heat exchanger 1025 may include a first heat sub-exchanger 10251 and a second heat sub-exchanger 10252, the first heat sub-exchanger 10251 may be disposed in the first cavity 101, and the second heat sub-exchanger 10252 may be disposed in the second cavity 102. When the first heat sub-exchanger 10251 and the second heat sub-exchanger 10252 are specifically disposed, refer to the power device shown in FIG. 6. Details are not described herein again. In addition, other structures of the power device shown in FIG. 12 may be disposed with reference to the power device shown in FIG. 6, and only disposing angles of the other structures need to be adaptively adjusted based on a direction in which the first cavity 101 and the second cavity 102 are arranged. Details are not described herein.

In another possible implementation of this application, when the heat exchanger 1025 includes the first heat sub-exchanger 10251 and the second heat sub-exchanger 10252, the second heat sub-exchanger 10252 may alternatively be integrated into the condenser 202. During specific implementation, refer to a power device shown in FIG. 13. In this case, the second heat sub-exchanger 10252 and the condenser 202 may share one evaporator 201, so that integration of the power device can be effectively improved, and a miniaturization design of the power device is facilitated.

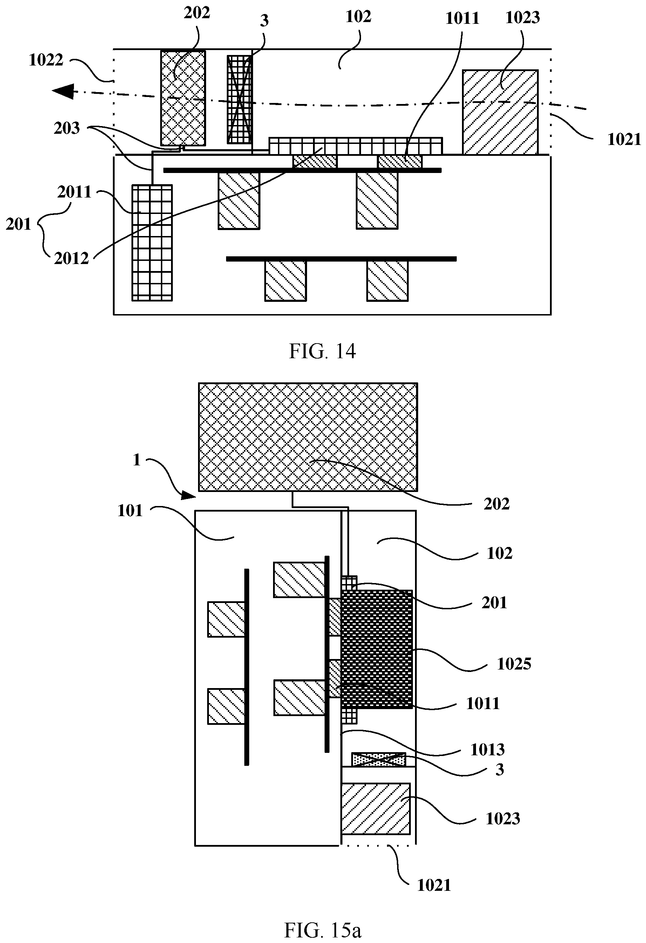

In the horizontal power device, the evaporator 201 may alternatively be disposed as a split structure. For example, in a power device shown in FIG. 14, the evaporator 201 may include a first sub-evaporator 2011 and a second sub-evaporator 2012. The first sub-evaporator 2011 is disposed in the first cavity 101, the second sub-evaporator 2012 is disposed in the second cavity 102, and the first sub-evaporator 2011 and the second sub-evaporator 2012 may share one condenser 202, that is, the first sub-evaporator 2011 and the second sub-evaporator 2012 may be connected to the same condenser 202 through the two-phase pipeline 203 respectively, so that integration of the radiator 2 can be effectively improved, and space occupied by the radiator 2 is small. In addition, for a specific manner in which the first sub-evaporator 2011 is disposed in the first cavity 101 and a specific manner in which the second sub-evaporator 2012 is disposed in the second cavity 102, refer to the power device shown in FIG. 8. Details are not described herein again. In addition, other structures of the power device shown in FIG. 14 may be disposed with reference to the power device shown in FIG. 8, and only disposing angles of the other structures need to be adaptively adjusted based on a direction in which the first cavity 101 and the second cavity 102 are arranged. Details are not described herein.

In each of the foregoing power devices, the entire radiator 2 is disposed in the second cavity 102, so that the entire radiator 2 and the second to-be-heat-dissipated component 1023 share the first fan 3 and the first air channel. However, in another possible embodiment of this application, the second to-be-heat-dissipated component 1023 and a part of the radiator 2 may alternatively share the first fan 3 and the first air channel. During specific implementation, refer to FIG. 15a. FIG. 15a is a side sectional view of another possible power device according to an embodiment of this application. The power device shown in FIG. 15a may also include the first cavity 101 and the second cavity 102, where the first cavity 101 and the second cavity 102 are disposed side by side.

In addition, the first to-be-heat-dissipated component 1011 may be disposed in the first cavity 101, the evaporator 201 and the second to-be-heat-dissipated component 1023 are disposed in the second cavity 102, and the evaporator 201 and the second to-be-heat-dissipated component 1023 may be disposed on the first side wall 1013. In the power device, the first side wall 1013 may be disposed in a gravity direction. The first to-be-heat-dissipated component 1011 may still be in thermally conductive contact with the evaporator 201 through a mounting hole penetrating the first side wall 1013, and the second to-be-heat-dissipated component 1023 may be electrically connected to a component in the first cavity 101 through a cable penetrating a through hole.

The second cavity 102 may have a first air inlet 1021 and a first air outlet 1022. The first fan 3 is disposed in the second cavity 102, an air inlet side of the first fan 3 faces the first air inlet 1021, and a first air outlet side of the first fan 3 faces an air outlet, so that an airflow flowing in a direction from the first air inlet 1021 to the first air outlet 1022 can be formed in the second cavity 102, that is, a first air channel is formed in the second cavity 102.

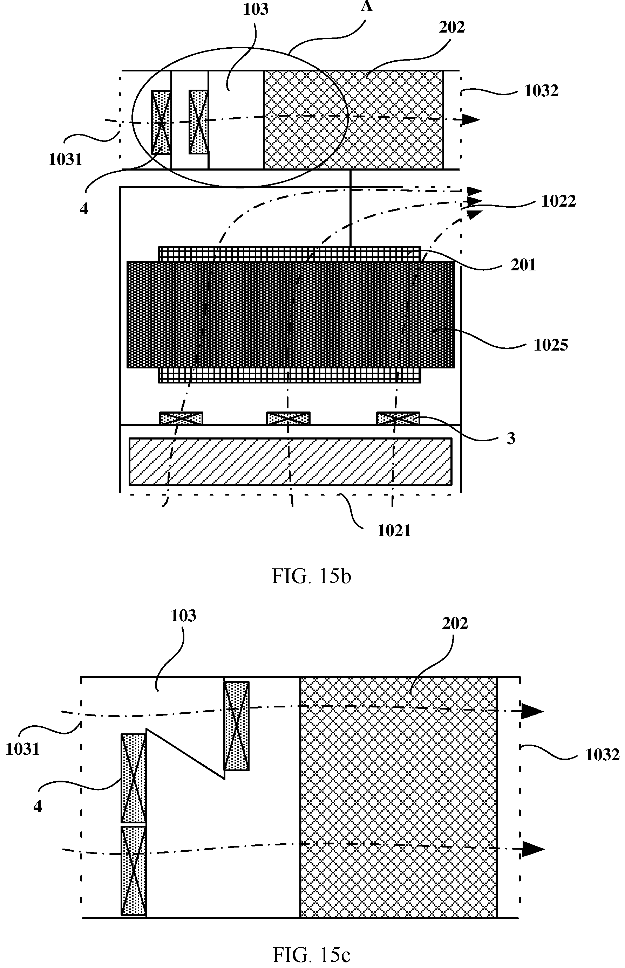

Different from the power device provided in the foregoing embodiment, the power device shown in FIG. 15a further includes a third cavity 103, and the condenser 202 may be disposed in the third cavity 103. FIG. 15b is a right view of the power device shown in FIG. 15a. Because the condenser 202 is located above the evaporator 201 when the power device is disposed in the gravity direction, the third cavity 103 may be located above the second cavity 102 in this direction. In addition, the third cavity 103 may have a second air inlet 1031 and a second air outlet 1032. To cool the condenser 202, a second fan 4 may be further disposed in the third cavity 103, an air inlet side of the second fan 4 is disposed toward the second air inlet 1031, and an air outlet side of the second fan 4 is disposed toward the second air outlet 1032, so that an airflow flowing in a direction from the second air inlet 1031 to the second air outlet 1032 may be formed in the third cavity 103, that is, a second air channel is formed in the third cavity 103.

Because the third cavity 103 is located above the second cavity 102 in the gravity direction, to prevent hot air discharged from the second cavity 102 from entering the third cavity 103, the first air outlet 1022 and the second air inlet 1031 may face different directions. For example, the first air inlet 1021 may be disposed in a direction away from the third cavity 103, and the first air outlet 1022 may be disposed on any side wall surface of the second cavity 102, or the first air outlet 1022 may be disposed at a joint of two adjacent side wall surfaces of the second cavity 102. In addition, the second air inlet 1031 and the second air outlet 1032 may be disposed opposite to each other, and the second air outlet 1032 and the first air outlet 1022 may face a same direction.

Still refer to FIG. 15b. To effectively increase a flow rate of an airflow in the first air channel, there may be at least two first fans 3 in the second cavity 102, the at least two first fans 3 are disposed side by side, and the at least two first fans 3 have a same air outlet side and air inlet side.

In addition, there may also be at least two second fans 4 in the third cavity 103, and the at least two second fans 4 have a same air outlet side and air inlet side. In a possible implementation, refer to FIG. 15c. FIG. 15c is an enlarged view of a partial structure of A in FIG. 15b. The at least two second fans 4 may be staggered in the direction from the second air inlet 1031 to the second air outlet 1032, so that space occupied by the at least two second fans 4 in the second cavity 102 can be effectively reduced, and a miniaturization design of the power device is facilitated.

Other structures of the power device shown in FIG. 15a may be disposed with reference to the power devices shown in FIG. 1 to FIG. 8. Details are not described herein again.

The power device provided in embodiments of this application can effectively improve heat dissipation efficiency of the heat dissipation apparatus for the first cavity 101 while a design requirement of related protection performance of the power device is met, thereby reducing the risk of the failure of the component in the first cavity 101, and improving use reliability of the power device. In addition, at least a part of the radiator 2, the first fan 3, and the second to-be-heat-dissipated component 1023 are all disposed in the second cavity 102, in other words, at least the part of the radiator 2 and the second to-be-heat-dissipated component 1023 share the first fan 3 and the first air channel, so that the size of the entire power device is small while implementing effective heat dissipation for the power device. Therefore, the heat dissipation capability of the power device provided in this application can be effectively improved, and the power density of the power device can be effectively increased. This can help improve the performance reliability of each component in the power device.

It should be understood that, in embodiments of this application, the component disposed in the first cavity is not limited to the first to-be-heat-dissipated component mentioned above. Similarly, the component disposed in the second cavity is not limited to the second to-be-heat-dissipated component mentioned above. In actual application, a matching component may be disposed based on a specific type of the power device. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An inverter, comprising a housing and a heat dissipation apparatus, wherein
the housing comprises a first cavity and a second cavity, a power semiconductor device is disposed in the first cavity, a magnetic component is disposed in the second cavity, and the second cavity has a first air inlet and a first air outlet; and
the heat dissipation apparatus comprises a radiator and a first fan, the radiator comprises an evaporator and a condenser, the evaporator is connected to the condenser through a two-phase pipeline, the evaporator is disposed in the second cavity, the power semiconductor device is in thermally conductive contact with the evaporator, the first fan is disposed in the second cavity, an air inlet side of the first fan is disposed toward the first air inlet, and an air outlet side of the first fan is disposed toward the first air outlet.

2. The inverter according to claim 1, wherein the condenser is disposed in the second cavity, and when the inverter is disposed in a gravity direction, the condenser is located above the evaporator.

3. The inverter according to claim 2, wherein when the inverter is disposed in the gravity direction, the condenser is located above the first cavity, the first air inlet is disposed in a direction from the condenser to the first cavity, and the first air outlet is disposed in a direction from the second cavity to the first cavity.

4. The inverter according to claim 3, wherein an air supplement vent is disposed in the second cavity, and the air supplement vent is located on a side that is of the condenser and that faces the first air inlet.

5. The inverter according to claim 2, wherein when the inverter is disposed in the gravity direction, the second cavity is located above the first cavity, and the first air inlet and the first air outlet are disposed opposite to each other.

6. The inverter according to claim 1, wherein the housing further comprises a third cavity, and the third cavity has a second air inlet and a second air outlet; and the heat dissipation apparatus further comprises a second fan, the second fan is disposed in the third cavity, an air inlet side of the second fan is disposed toward the second air inlet, and an air outlet side of the second fan is disposed toward the second air outlet; and
the condenser is disposed in the third cavity, and when the inverter is disposed in a gravity direction, the condenser is located above the evaporator.

7. The inverter according to claim 6, wherein the heat dissipation apparatus comprises at least two second fans, the second air inlet and the second air outlet are disposed opposite to each other, and the at least two second fans are staggered in a direction from the second air inlet to the second air outlet.

8. The inverter according to claim 6 or 7, wherein the first air outlet and the second air outlet face a same direction.

9. The inverter according to any one of claims 1 to 8, wherein the evaporator comprises a substrate and a heat dissipation fin, the power semiconductor device is in thermally conductive contact with the substrate, and the heat dissipation fin is disposed on a side that is of the substrate and that is away from the first cavity.

10. The inverter according to any one of claims 1 to 8, wherein the evaporator comprises a first sub-evaporator and a second sub-evaporator, the first sub-evaporator is disposed in the first cavity, the second sub-evaporator is disposed in the second cavity, the power semiconductor device is in thermally conductive contact with the second sub-evaporator, and the first sub-evaporator and the second sub-evaporator are connected to the condenser through the two-phase pipeline respectively.

11. The inverter according to any one of claims 1 to 8, wherein the inverter further comprises a heat exchanger, the heat exchanger is disposed in the second cavity, and the heat exchanger is disposed on a first side wall of the first cavity; and
the heat exchanger comprises an air supply vent and an air return vent, a first ventilation vent and a second ventilation vent are disposed on the first side wall, the air supply vent communicates with the first cavity through the first ventilation vent, and the air return vent communicates with the first cavity through the second ventilation vent.

12. The inverter according to any one of claims 1 to 8, wherein the power device further comprises a heat exchanger, the heat exchanger comprises a first heat sub-exchanger and a second heat sub-exchanger, the first heat sub-exchanger is disposed in the first cavity, the second heat sub-exchanger is disposed in the second cavity or integrated with the condenser, and the first heat sub-exchanger is in a thermally conductive connection to the second heat sub-exchanger.

13. A power device, comprising a housing and a heat dissipation apparatus, wherein
the housing comprises a first cavity and a second cavity, a first ventilation vent and a second ventilation vent are disposed on a first side wall of the first cavity, the second cavity has a first air inlet and a first air outlet, a first to-be-heat-dissipated component is disposed in the first cavity, a second to-be-heat-dissipated component or a heat exchanger is disposed in the second cavity, the heat exchanger comprises an air supply vent and an air return vent, the air supply vent communicates with the first cavity through the first ventilation vent, and the air return vent communicates with the first cavity through the second ventilation vent; and
the heat dissipation apparatus comprises a radiator and a first fan, the radiator comprises an evaporator and a condenser, the evaporator is connected to the condenser through a two-phase pipeline, the evaporator is disposed in the second cavity, the first to-be-heat-dissipated component is in thermally conductive contact with the evaporator, the first fan is disposed in the second cavity, an air inlet side of the first fan is disposed toward the first air inlet, and an air outlet side of the first fan is disposed toward the first air outlet.

14. A photovoltaic system, comprising a photovoltaic panel and the inverter according to any one of claims 1 to 12 or the power device according to claim 13, wherein the photovoltaic panel is configured to convert solar energy into electric energy, and the inverter or the power device is configured to convert a current and/or a voltage from the photovoltaic panel.

15. A photovoltaic system, comprising at least two power devices, wherein the power device comprises a housing and a heat dissipation apparatus, wherein
the housing comprises a first cavity and a second cavity, a first to-be-heat-dissipated component is disposed in the first cavity, the second cavity has a first air inlet, a first air outlet, and an air supplement vent, and a second to-be-heat-dissipated component is disposed in the second cavity;
the heat dissipation apparatus comprises a radiator and a first fan, the radiator is disposed in the second cavity, the radiator comprises an evaporator and a condenser, the evaporator is connected to the condenser through a two-phase pipeline, the first to-be-heat-dissipated component is in thermally conductive contact with the evaporator, the first fan is disposed in the second cavity, an air inlet side of the first fan is disposed toward the first air inlet, and an air outlet side of the first fan is disposed toward the first air outlet;
when the power device is disposed in a gravity direction, the condenser is located above the first cavity, the first air inlet is disposed in a direction from the condenser to the first cavity, the first air outlet is disposed in a direction from the second cavity to the first cavity, and the air supplement vent is located on a side that is of the condenser and that faces the first air inlet; and
an air deflector plate is disposed between the two adjacent power devices, and in a direction in which the at least two power devices are arranged, the air deflector plate is configured to separate the air supplement vent of the former power device from the first air outlet of the latter power device.
